# EUROPÄISCHE PATENTSCHRIFT

(11) **EP 0 419 995 B1**
(45) Veröffentlichungstag und Bekanntmachung des Hinweises auf die Patenterteilung: **09.06.1993**
(21) Anmeldenummer: 90117873.1
(22) Anmeldetag: 17.09.1990
(51) Int. Cl.: B23K 3/047, H05K 13/04

(54) **Lötvorrichtung zum Auflöten von Bauelementen auf Leiterplatten**
Soldering device for soldering components onto printed circuit boards
Dispositif de soudage pour souder des composants sur des plaquettes à circuits imprimés

(30) Priorität: 29.09.1989 DE 3932651
(43) Veröffentlichungstag der Anmeldung: 03.04.1991
(73) Patentinhaber: Siemens Nixdorf Informationssysteme Aktiengesellschaft, 33102 Paderborn (DE)
(72) Erfinder: Raschke, Josef, D-8011 Gelting (DE); Schuster, Rudolf, D-8011 Heimstetten (DE)
(74) Vertreter: Fuchs, Franz-Josef, Dr.-Ing.

(56) Entgegenhaltungen:
- DE-A- 3 624 728
- ELECTRONIC PACKAGING AND PRODUCTION. vol. 28, no. 2, Februar 1988, Newton, Mass., USA, Seite 14 "Soldering machines take on quad flat packs"

## Beschreibung

Die Erfindung betrifft eine Lötvorrichtung zum Auflöten von Bauelementen auf Leiterplatten mit mindestens zwei an einem Lötbügelhalter befestigten und durch elektrische Widerstandswärme erhitzbaren Bügelelektroden und mit einer mittig zwischen den Bügelelektroden angeordneten Saugpipette zum Aufnehmen, Transportieren und Aufsetzen der Bauelemente auf die zugeordneten Lötstellen, siehe Z.B.: "Electronic packaging and production", vol. 28, no. 2, Februar 1988, Newton, Massachussets, USA, Seite 14.

Lötvorrichtungen mit zwei parallel einander gegenüberliegenden oder mit vier paarweise einander gegenüberliegenden Bügelelektroden werden insbesondere für das Auflöten hochpoliger elektronischer Bauelemente wie Mikropacks, Flatpacks und dergleichen eingesetzt. Wird nun eine derartige Lötvorrichtung zusätzlich mit einer mittig zwischen den Bügelelektroden angeordneten Saugpipette ausgerüstet, so kann diese für die automatische Bestückung der Leiterplatten mit den aufzulötenden Bauelementen herangezogen werden. Bei der Bestückung nach dem sogenannten Pick & Place Prinzip bewegt sich der kombinierte Bestück- und Lötkopf über den Zuführmodulen der Bauelemente und der im Bestückbereich angeordneten Leiterplatte, wobei die Saugpipette das jeweilige Bauelement aus einem Zuführmodul aufnimmt und in der vorgegebenen Bestückposition auf der Leiterplatte absetzt. Nach dem Absetzen des jeweiligen Bauelements wird dann der Lötbügelhalter abgesenkt, so daß sich sowohl vor dem Lötvorgang als auch während der gesamten Dauer des Lötvorganges ein möglichst sicherer Kontakt zwischen den Arbeitsflächen der Bügelelektroden, den Anschlußbeinchen des Bauelements und den Leiterbahnen bzw. Anschlußpads der Leiterplatte ergibt. Die Saugpipette verbleibt bis zur Beendigung dem Lötvorganges auf dem Bauelement und drückt dieses dabei mit einer begrenzten Kraft gegen die Lötstelle auf der Leiterplatte.

Bei dem durch die elektrische Widerstandserwärmung der Bügelelektroden ausgelösten Lötvorgang entstehen Lötdämpfe, welche sowohl flüchtige Bestandteile wie Verdünnungsmittel der verwendeten Flußmittel als auch feste Bestandteile der verwendeten Flußmittel wie z.B. Kolophonium enthalten können. Die bereits vor Erreichen der Löttemperatur entstehenden Lötdämpfe schlagen sich dann an kälteren Stellen der Lötvorrichtung nieder, wobei dieser Niederschlag insbesondere im Bereich mechanischer Führungen, im Bereich von Lagerungen oder Gelenken und im Bereich elektrischer Kontakte zu einer Zerstörung oder zumindest zu einer erheblichen Beeinträchtigung führen kann. Eine manuelle Entfernung der Niederschläge - wie sie bei einem gelegentlichen Einsatz der Lötvorrichtung noch möglich ist - muß bei einem Einsatz der Lötvorrichtung in der Massenfertigung ausgeschlossen werden.

Der Erfindung liegt die Aufgabe zugrunde, bei einer Lötvorrichtung der eingangs genannten Art einen Niederschlag von Lötdämpfen auf empfindlichen Teilen der Vorrichtung zumindest weitgehend zu verhindern.

Diese Aufgabe wird bei einer Lötvorrichtung der eingangs genannten Art durch eine Abzugseinrichtung für Lötdämpfe gelöst, deren ringförmige Absaugöffnung zwischen Saugpipette und Lötbügelhalter angeordnet ist.

Bei der erfindungsgemäßen Lötvorrichtung werden die beim Lötvorgang entstehenden Lötdämpfe also abgesaugt, wobei diese Absaugung im Bereich der gesamten Löstelle möglichst effektiv und möglichst gleichmäßig sein sollte. Da eine Absaugung mit zwei oder mehreren Absaugöffnungen zu einer gegenseitigen Beeinträchtigung und der Bildung von neutralen Zonen führen würde, ist bei der erfindungsgemäßen Abzugeinrichtung nur eine einzige Absaugöffnung vorgesehen, die oberhalb der Lötstelle zwischen Saugpipette und Lötbügelhalter angeordnet ist und koaxial zur Saugpipette ausgerichtet ist. Hierdurch wird ein unerwünschter Niederschlag von Lötmitteldämpfen auf empfindliche Teile der Lötvorrichtung wie mechanische Führungen und elektrische Kontakte zumindest weitgehend ausgeschlossen. Ein möglicher Niederschlag der Lötmitteldämpfe auf der Saugpipette wird dabei bewußt in Kauf genommen, da die Saugpipette ohne besonderen Aufwand in gewissen Zeitabständen entommen und außerhalb der Lötvorrichtung gereinigt oder gewechselt werden kann.

Gemäß einer bevorzugten Ausgestaltung der Erfindung mündet die Absaugöffnung in eine oberhalb des Lötbügelhalters angeordnete und mit mindestens einem Absaugstutzen versehen Absaugkammer ein. Hierdurch wird die gesamte Abzugseinrichtung an zentraler Stelle in die Lötvorrichtung integriert, wobei nur noch der Absaugstutzen zur Beschleunigung des Abzugs der Lötdämpfe an einen Ventilator oder dergleichen angeschlossen werden muß. Die obere Durchtrittsöffnung der Saugpipette durc die Absaugkammer wird dann zweckmäßigerweise abgedichtet. Wird die obere Durchtrittsöffnung durch einen elastischen Balg abgedichtet, so können die erforderlichen Verschiebungen zwischen Saupipette und Abzugkammer mit besonders geringem Aufwand gewährleistet werden.

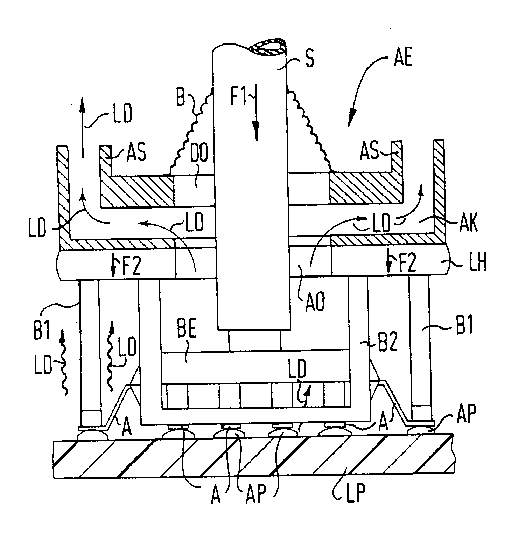

Ein Ausführungsbeispiel der Erfindung ist in der Zeichnung dargestellt und wird im folgenden näher beschrieben.

Die Zeichnung zeigt in stark vereinfachter schematischer Darstellung das Grundprinzip einer erfindungsgemäßen Lötvorrichtung, wobei die zum Verständnis der Erfindung nicht erforderlichen Teile wie Stromzuführungen und dergleichen weggelassen wurden. Die dargestellte Lötvorrichtung besitzt vier an einem Lötbügelhalter LH befestigte U-förmige Bügelelektroden, wobei jeweils zwei Bügelelektroden B1 und zwei Bügelelektroden B2 derart im Abstand zueinander parallel ausgerichtet sind, daß die Arbeitsflächen auf der Unterseite der Bügelelektroden B1 und B2 einen in den Eckbereichen nicht geschlossenen rechteckförmigen oder quadratischen Rahmen bilden. Die Abmessungen dieses Rahmens sind dabei auf die Form und Lage der Anschlußbeinchen A eines auf die Anschlußpads AP einer Leiterplatte LP aufzulötenden Bauelementes BE abgestimmt.

Die Bauelemente BE werden mit der Saugpipette S eines in der Zeichnung nicht näher dargestellten Bestückkopfes aus einem Magazin oder aus einem Zuführmodul entnommen und auf die vorgegebene Lötstelle auf der Leiterplatte LP abgesetzt. Aufbau und Wirkungsweise eines mit einer Saugpipette ausgerüsteten Bestückkopfes gehen beispielsweise aus der US-A-4 135 630 hervor.

Beim Aufsetzen des Bauelements BE auf die vorgegebene Lötstelle auf der Leiterplatte LP kommen die Anschlußbeinchen A mit den zugeordneten Anschlußpads AP in Kontakt. Dabei wird die Saugpipette S zusätzlich dazu benutzt, das Bauelement BE mit einer begrenzten Kraft F1 von beispielswiees 0,1 bis 0,5 N bis zur Beendigung des Lötvorganges gegen die Leiterplatte LP zu drücken. Nach dem Aufsetzen des Bauelements BE wird dann der Lötbügelhalter LH nach unten in die in der Zeichnung dargestellte Lage gefahren, wobei die Arbeitsflächen der Bügelelektroden B1 und B2 die Anschlußbeinchen A mit einer Kraft F2 von beispielsweise 40 N gegen die zugeordneten Anschlußpads AP dürcken. Der eigentliche Lötvorgang erfolgt dann durch das Aufschmelzen des Lotes der Anschlußpads AP als Folge einer entsprechenden elektrischen Widerstandserwärmung der Bügelelektroden B1 und B2.

Bei der Erwärmung der Arbeitsflächen der Bügelelektroden B1 und B2 kommt es schon vor dem Erreichen der Löttemperatur zur Bildung von Lötdämpfen LD, die insbesondere Bestandteile des verwendeten Flußmittels wie Lösungsmittel und Kolophonium enthalten. Um einen unerwünschten Niederschlag dieser Lötdämpfe LD auf empfindlichen mechanischen oder elektrischen Teilen zu verhindern, ist eine insgesamt mit AE bezeichnete Abzugseinrichtung vorgesehen, deren Absaugöffnung AO zwischen der Saugpipette S und einer dazu koaxial angeordneten Öffnung des Lötbügelhalters LH gebildet ist. Diese Absaugöffnung AO mündet in eine auf dem Lötbügelhalter LH angeordnete Absaugkammer AK ein, die ebenfalls koaxial zur Saugpipette S angeordnet ist und zwei einander gegenüberliegende Absaugstutzen AS besitzt. Diese Absaugstutzen AS werden zur Erzeugung des erforderlichen Zuges an in der Zeichnung nicht dargestellte Ventilatoren angeschlossen.

Es ist ferner zu erkennen, daß die obere Durchtrittsöffnung DO der Saugpipette S durch die Absaugkammer AK mit Hilfe eines elastischen Balges B abgedichtet ist, welcher ein getrenntes Heben und Senken von Saugpipette S einerseits und Lötbügelhalter LH mit Absaugkammer AK andererseits zuläßt.

Wie bereits erwähnt wurde, dient die vorstehend beschriebene Absaugung von Lötdämpfen zum Schutz empfindlicher elektrischer und mechanischer Teile. Bei den empfindlichen elektrischen Teilen handelt es sich insbesondere um die Kontaktstellen der Stromzufuhr und die Kontaktstellen von Thermoelementen. Bei den empfindlichen mechanischen Teilen handelt es sich insbesondere um Führungen, die das Heben und Senken des Lötbügelhalters und das Heben und Senken der Saugpipette ermöglichen. Auch bei einer gelenkigen Aufhängung des Lötbügelhalters dient die Absaugung der Lötdämpfe zum Schutz der entsprechenden Gelenke. Eine derartige gelenkige Aufhängung des Lötbügelhalters zur Gewährleistung eines sicheren Kontaktes zwischen den Arbeitsflächen der Bügelelektrode, den Anschlußbeinchen eines aufzulötenden Bauelementes und den Anschlußpads ist beispielsweise in der EP-A- 377 874 (die unter Art. 54(3) EPÜ fällt) dargestellt und beschrieben.

## Patentansprüche

1. Lötvorrichtung zum Auflöten von Bauelementen (BE) auf Leiterplatten (LP), mit mindestens zwei an einem Lötbügelhalter (LH) befestigten und durch elektrische Widerstandswärme erhitzbaren Bügelelektroden (B1,B2) und mit einer mittig zwischen den Bügelelektroden (B1,B2) angeordneten Saugpipette (S) zum Aufnehmen, Transportieren und Aufsetzen der Bauelemente (BE) auf die zugeordneten Lötstellen,
**gekennzeichnet durch,**
eine Abzugseinrichtung (AE) für Lötdämpfe (LD) deren ringförmige Absaugöffnung (AO) zwischen Saugpipette (S) und Lötbügelhalter (LH) angeordnet ist.

2. Lötvorrichtung nach Anspruch 1,
**dadurch gekennzeichnet,**
daß die Absaugöffnung (AO) in eine oberhalb des Lötbügelhalters (LH) angeordnete und mit mindestens einem Absaugstutzen (AS) versehene Absaugkammer (AK) einmündet.

3. Lötvorrichtung nach Anspruch 2,
**dadurch gekennzeichnet,**
daß die obere Durchtrittsöffnung (DO) der Saugpipette (S) durch die Absaugkammer (AK) abgedichtet ist.

4. Lötvorrichtung nach Anspruch 3,
**dadurch gekennzeichnet,**
daß die obere Durchtrittsöffnung (DO) durch einen elastischen Balg (B) abgedichtet ist.

## Claims

1. Soldering device for soldering components (BE) onto printed circuit boards (LP), having at least two stirrup electrodes (B1, B2) mounted on a soldering stirrup holder (LH) and heatable by electrical resistance heat, and having suction pipette (S) arranged centrally between the stirrup electrodes (B1, B2) for picking up, conveying and setting the components (BE) down on the allotted soldering positions, characterised by an extraction device (AE) for solder vapours (LD) whose annular suction opening (AO) is arranged between the suction pipette (S) and soldering stirrup holder (LH).

2. Soldering device according to Claim 1, characterised in that the suction opening (AO) opens into a suction chamber (AK) arranged above the soldering stirrup holder (LH) and provided with at least one suction connection pipe (AS).

3. Soldering device according to Claim 2, characterised in that the upper passage opening (DO) of the suction pipette (S) through the suction chamber (AK) is sealed.

4. Soldering device according to Claim 3, characterised in that the upper passage opening (DO) is sealed by an elastic bellows (B).

## Revendications

1. Dispositif de brasage pour fixer par brasage des composants (BE) sur des plaquettes à circuits imprimés (LP), comportant au moins deux électrodes en forme d'étriers (B1,B2), qui sont fixées à un support (LH) d'étriers de brasage et qui peuvent être chauffées par une chaleur produite par une résistance électrique, et comportant une pipette d'aspiration (S), qui est disposée en position centrée entre les électrodes en forme d'étriers (B1,B2), pour recevoir, transporter et déposer les composants (BE) au niveau des points de brasage associés, caractérisé par un dispositif (AE) d'évacuation des vapeurs de brasage (LD), dont l'ouverture annulaire d'aspiration (AO) est disposée entre la pipette d'aspiration (S) et le support (LH) des étriers de brasage.

2. Dispositif de brasage suivant la revendication 1, caractérisé par le fait que l'ouverture d'aspiration (AO) débouche dans une chambre d'aspiration (AK), qui est disposée au-dessus du support (LH) des étriers de brasage et qui est pourvue d'au moins une tubulure d'aspiration (AS).

3. Dispositif de brasage suivant la revendication 2, caractérisé par le fait que l'ouverture supérieure de passage (DO) de la pipette d'aspiration (S) est étanchifié par la chambre d'aspiration (AK).

4. Dispositif de brasage suivant la revendication 3, caractérisé par le fait que l'ouverture de passage supérieure (DO) est étanchéifiée par un soufflet élastique (B).
